Europäisches Patentamt

European Patent Office

Office européen des brevets

(11) Veröffentlichungsnummer: **0 044 411**
A1

## (12) EUROPÄISCHE PATENTANMELDUNG

(21) Anmeldenummer: 81104692.9

(22) Anmeldetag: 19.06.81

(51) Int. Cl.³: **C 08 L 49/00**
**H 01 B 1/12, H 01 L 29/28**
**H 01 L 31/02**

(30) Priorität: 19.07.80 DE 3027529

(43) Veröffentlichungstag der Anmeldung:
27.01.82 Patentblatt 82/4

(84) Benannte Vertragsstaaten:
BE CH DE FR GB LI NL

(71) Anmelder: BASF Aktiengesellschaft
Carl-Bosch-Strasse 38
D-6700 Ludwigshafen(DE)

(72) Erfinder: Muench, Volker, Dr.
Luitpoldstrasse 114
D-6700 Ludwigshafen(DE)

(72) Erfinder: Naarmann, Herbert, Dr.
Haardtblick 15
D-6719 Wattenheim(DE)

(72) Erfinder: Penzien, Klaus, Dr.
Bensheimer Ring 18
D-6710 Frankenthal(DE)

(54) Verfahren zur Herstellung von elektrisch leitfähigen polymeren Systemen und deren Verwendung in der Elektrotechnik und zur antistatischen Ausrüstung von Kunststoffen.

㊐ Die Erfindung betrifft ein Verfahren zur Herstellung von elektrisch leitfähigen Polymeren mit elektrischen Leitfähigkeitswerten größer als $10^{-2}$/S/cm, wobei man organischen Polymeren aus der Reihe der Polyphenylene, Heteropolyphenylene oder Polyacetylene unter Ausschluß von Wasserfeuchtigkeit und von Sauerstoff schwarzen Phosphor in Mengen von 0,1 bis 95 Gew.% und Natrium, Kalium, Rubidium, Cäsium oder deren Amide bevorzugt in Tetrahydrofuran, Dimethoxyglykol, Anthrazen, Naphthalin oder 2-Methylstyrol jeweils im Molverhältnis 1 : 1 bis 1 : 5 in Mengen von 0,5 bis 25 Gew.% zusetzt.

Die hergestellten, elektrisch leitfähigen Polymeren können in der Elektrotechnik zur Herstellung von Sonnenzellen, zur Umwandlung und Fixierung von Strahlung, zur Herstellung elektrischer und magnetischer Schalter oder zur antistatischen Ausrüstung von Kunststoffen verwendet werden.

EP 0 044 411 A1

0044411

BASF Aktiengesellschaft

O.Z. 0050/034567

Verfahren zur Herstellung von elektrisch leitfähigen
polymeren Systemen und deren Verwendung in der Elektrotechnik und zur antistatischen Ausrüstung von Kunststoffen

Die Erfindung betrifft ein Verfahren zur Herstellung von
elektrisch leitfähigen Polymeren mit elektrischen Leitfähigkeitswerten größer als $10^{-2}$ S/cm und deren Verwendung in der
Elektroindustrie zur Herstellung von Sonnenzellen, zur
Umwandlung und Fixierung von Strahlung und zur Herstellung
elektrischer und magnetischer Schalter sowie zur antistatischen Ausrüstung von Kunststoffen.

Es ist bereits bekannt, organische Polymere aus der Reihe
der Polyphenylene durch oxidative Kupplung entsprechend
der Literatur: "Macromolecular Syntheses Collective", 1,
(1979), Seiten 109 bis 110 und "Naturwiss." 56 (1969),
Seiten 308 bis 313, herzustellen. Außerdem ist die Herstellung von Polyphenylenen durch stufenweise Polykondensation nach R. Gehm und W. Kern aus "Makromolekulare
Chemie" 7 (1951), Seiten 46 bis 61, bekannt, wobei besonders einheitliche para-verkettete methylsubstituierte
Derivate erhalten werden, die nicht zusätzlich durch
ortho- oder meta-verknüpfte Polymere verunreinigt sind.
Die organischen Polymeren aus der Reihe der Heteropolyphenylene unterscheiden sich von den Polyphenylenen durch
das Vorhandensein von Heteroatomen oder Heteroatome enthaltenden Gruppen zwischen den aromatischen Ringsystemen.
Diese Polymeren sind z.B. beschrieben in "Macromolecular
Synthesis", 6, (1978), Seiten 45 bis 48. Auch die Herstellung der organischen Polymere aus der Reihe der Polyacetylene durch Polymerisation von Acetylen ist bekannt.
Sie ist z.B. in den Arbeiten von Hatano in "J. Chem. Soc.
Japan, Ind. Chem. Sect." 65, (1962), Seite 723 ff. sowie
von D.J. Berets et al. "Trans. Farad. Soc." 64, (1968),
Seite 823 ff. beschrieben. Auch in neueren Publikationen

Fre/BL

von H. Shirakawa et al., "J. Chem. Soc., Chem. Comn." 1977, Seiten 578 bis 580 ist die Polymerisation von Acetylen zu Polyacetylen mit Hilfe von Ziegler-Katalysatoren beschrieben. Nach den genannten Methoden werden Produkte erhalten, die in den üblichen Lösungsmitteln vollkommen unlöslich sind und als schwarze amorphe bis teilkristalline Materialien anfallen. Auch die in den "Ber. Bunsenges. Phys. Chem." 68, (1964), Seiten 558 bis 567 erhaltenen Materialien werden mit umfaßt.

Der Erfindung lag die Aufgabe zugrunde, die an sich bekannten organischen Polymeren aus der Reihe der Polyphenylene, Heteropolyphenylene oder Polyacetylene durch Zusätze in elektrisch leitfähige Polymere mit elektrischen Leitfähigkeitswerten größer als $10^{-2}$ S/cm umzuwandeln und darüber hinaus entscheidend gegen oxidative Schädigung zu stabilisieren und die Verarbeitbarkeit und Anwendungsbreite deutlich zu erhöhen.

Diese Aufgabe wird erfindungsgemäß dadurch gelöst, daß man den organischen Polymeren aus der Reihe der Polyphenylene, Heteropolyphenylene oder Polyacetylene unter Ausschluß von Wasserfeuchtigkeit und von Sauerstoff 0,1 bis 95 Gew.%, bezogen auf das Polymere, schwarzem Phosphor und 0,5 bis 25 Gew.%, bezogen auf das eingesetzte organische Polymere, an Natrium, Kalium, Rubidium, Cäsium oder deren Amiden zusetzt. Nach bevorzugter Verfahrensweise wird Na, K, Rb, Cs oder deren Amide in Tetrahydrofuran, Dimethoxyglykol, Anthrazen, Naphthalin oder 2-Methylstyrol, jeweils im Molverhältnis 1 : 1 bis 1 : 50, vorzugsweise 1 : 2 bis 1 : 3, zugesetzt.

"Die elektrischen Leitfähigkeitswerte werden in S/cm bei $30^{\circ}C$ gemessen, die Messung selbst erfolgt nach der Methode von F. Beck, "Berichte Bunsengesellschaft, Physikalische Chemie" 68 (1964), Seiten 558 bis 567. Die elektrische Leitfähigkeitswerte der erfindungsgemäßen leitfähigen Polymeren ist größer als $10^{-2}$ S/cm.

Nach dem erfindungsgemäßen Verfahren wird den organischen Polymeren unter Ausschluß von Wasserfeuchtigkeit und von Sauerstoff, 0,1 bis 95 Gew.%, bezogen auf das Gewicht des Polymeren, schwarzem Phosphor und 0,5 bis 25 Gew.%, bezogen auf das eingesetzte Polymere, ein Alkalimetall oder deren Amid zugesetzt.

Das Einarbeiten der Zusätze erfolgt unter Ausschluß von Feuchtigkeit (Wasser) sowie Sauerstoff (Luft), es wird daher vorzugsweise unter Edelgas-Argonatmosphäre gearbeitet. Gegebenenfalls werden Hilfsflüssigkeiten wie Tetrahydrofuran, Dimethoxyglykol, Nitromethan oder Methylenchlorid eingesetzt, die nach dem Einarbeiten bei Temperaturen unter $30^{\circ}C$ in Vakuum abgezogen werden.

Durch die genannten Zusätze können elektrische Leitfähigkeitsanstiege von einigen Größenordnungen erreicht werden. Die Ausgangsleitfähigkeit der organischen Polymeren betrugen $10^{-12}$ S/cm. Die erfindungsgemäßen organischen Polymeren haben Ausgangsleitfähigkeiten von weniger als $10^{-12}$ S/cm, liefern aber nach der Zugabe der erfindungsgemäßen Zusätze Leitfähigkeiten größer als $10^{-2}$ S/cm.

Die erfindungsgemäß hergestellten elektrisch leitfähigen polymeren Systeme mit elektrischen Leitfähigkeiten größer als $10^{-2}$ S/cm sind zur antistatischen Ausrüstung von Kunststoffen, zur Herstellung von Sonnenzellen, zur Umwandlung und Fixierung von Strahlung sowie zur Herstellung elektri-

˝scher und magnetischer Schalter geeignet. Durch die Zusätze der Alkalimetalle bzw. deren Amide mit schwarzem
Phosphor entstehen sog. n-Leiter (vgl. "J. Chem. Education", 46, (1969), Nr. 2, Seite 82).

Die in den folgenden Beispielen genannten Teile sind Gewichtsteile bzw. Molprozente.

Beispiele 1 bis 7

10 Teile eines organischen Polymeren werden unter Argonatmosphäre und Ausschluß von Feuchtigkeit mit dem jeweiligen Zusatzstoff versetzt, die Messung der elektrischen
Leitfähigkeit erfolgt nach F. Beck "Ber. Bunsenges. Phys.
Chem." 68, (1964), Seiten 558 bis 567.

r Tabelle

| Beispiel Nr. | organ. Polymeres Teile | P schwarz Teile | Zusatzstoff Art und Menge in Mol.% | | Leitfähigkeit S/cm 30°C vor dem Zusatz | nach dem Zusatz |
|---|---|---|---|---|---|---|
| | 10 | | | | | |
| 1 | Polyacetylen nach Shirakawa 1) | 1 | Na | 0,5 | $10^{-10}$ | $6,5 \cdot 10^{+2}$ |
| 2 | " | 0,5 | K | 0,5 | $10^{-10}$ | $3,0 \cdot 10^{+2}$ |
| 3 | " | 2 | Cs | 0,3 | $10^{-10}$ | $0,5 \cdot 10^{+2}$ |
| 4 | " | 2 | Na[3] | 0,2 | $10^{-10}$ | $0,8 \cdot 10^{+2}$ |
| 5 | " | 10 | Na[3] | 0,5 | $10^{-10}$ | $1,7 \cdot 10^{+2}$ |
| 6 | " | 10 | Na[3] | 1,0 | $10^{-10}$ | $4,5 \cdot 10^{+2}$ |
| 7 | Polyacetylen nach Lüttinger 2) | 1 | Na[3] | 0,5 | $10^{-10}$ | $0,2 \cdot 10^{+1}$ |
| 8 | Polyacetylen nach Shirakawa 1) | 1 | Na[4] | 0,5 | $10^{-10}$ | $0,5 \cdot 10^{+1}$ |
| 9 | " | 1 | Na[4] | 0,7 | $10^{-10}$ | $0,9 \cdot 10^{+1}$ |
| 10 | " | 1 | Na[4] | 0,8 | $10^{-10}$ | $0,6 \cdot 10^{+2}$ |
| 11 | " | 1 | Na[4] | 1,2 | $10^{-10}$ | $0,8 \cdot 10^{+1}$ |

1) J. Chem. Soc., Chem. Commn. 1977, 578 ff.

2) J. Org. Chem. 29 (1964) 2936 ff.

3) Na als Na-Naphthalid, 2,5 %ig in Tetrahydrofuran

4) Na in flüssigem $NH_3$

BASF Aktiengesellschaft

O.Z.0050/034567

- 5 -

0044411

BASF Aktiengesellschaft — 6 — O.Z. 0050/034567

Patentansprüche

1. Verfahren zur Herstellung von elektrisch leitfähigen Polymeren mit elektrischen Leitfähigkeitswerten größer als $10^{-2}$ S/cm, dadurch gekennzeichnet, daß man organischen Polymeren aus der Reihe der Polyphenylene, Heteropolyphenylene oder Polyacetylene unter Ausschluß von Wasserfeuchtigkeit und von Sauerstoff schwarzen Phosphor in Mengen von 0,1 bis 95 Gew.%, bezogen auf das Polymere, und 0,5 bis 25 Gew.%, bezogen auf das Polymere, an Natrium, Kalium, Rubidium, Cäsium oder deren Amiden zusetzt.

2. Verfahren nach Anspruch 1, dadurch gekennzeichnet, daß Na, K, Rb, Cs oder deren Amide in Tetrahydrofuran, Dimethoxyglykol, Anthrazen, Naphthalin oder 2-Methylstyrol jeweils im Molverhältnis 1 : 1 bis 1 : 5, vorzugsweise 1 : 2 bis 1 : 3 zugesetzt wird.

3. Verwendung der nach Anspruch 1 hergestellten, elektrisch leitfähigen Polymeren in der Elektrotechnik zur Herstellung von Sonnenzellen, zur Umwandlung und Fixierung von Strahlung und zur Herstellung elektrischer und magnetischer Schalter.

4. Verwendung der nach Anspruch 1 hergestellten, elektrisch leitfähigen Polymeren zur antistatischen Ausrüstung von Kunststoffen.

0044411

Nummer der Anmeldung

EP 81 10 4692

**Europäisches Patentamt**

## EUROPÄISCHER RECHERCHENBERICHT

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | US - A - 4 204 216 (A. HEEGER et al.)<br><br>* Ansprüche *<br><br>--<br><br>JOURNAL OF CHEMICAL PHYSICS, Band 71, Nr. 3, August 1979, Seiten 1506-1507<br>D.M. IVORY et al.: "Highly conducting charge-transfer complexes of poly(p-phenylene)"<br><br>* Seite 1507, Spalte 1, Zeilen 34-42 * | 1-3 | C 08 L 49/00<br>H 01 B 1/12<br>H 01 L 29/28<br>31/02 |
| | | | **RECHERCHIERTE SACHGEBIETE (Int. Cl.³)** |
| P | EP - A - 0 016 305 (ALLIED CHEMI-CAL CORP.)<br><br>* Ansprüche 1,3,10 *<br><br>-- | 1-4 | C 08 L 49/00<br>65/02<br>H 01 B 1/12<br>H 01 L 29/28<br>31/02 |
| P | EP - A - 0 023 595 (BASF A.G.)<br>* Ansprüche *<br><br>---- | 1-4 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 27-10-1981 | HOFFMANN |

EPA form 1503.1   06.78